# EUROPÄISCHE PATENTANMELDUNG

(11) **EP 1 094 610 A1**
(43) Veröffentlichungstag der Anmeldung: **25.04.2001**
(21) Anmeldenummer: 00120322.3
(22) Anmeldetag: 15.09.2000
(51) Int. Cl.: H03L 7/099, H03K 3/03, H04J 3/07

(54) **Digitaler Phasenregelkreis**

(30) Priorität: 29.09.1999 DE 19946764
(71) Anmelder: SIEMENS AKTIENGESELLSCHAFT, 80333 München (DE)
(72) Erfinder: Eilken, Jens-Peter, 81475 München (DE); Siebert, Harry, 82110 Germering (DE)

(57) **Zusammenfassung**

Zur Regelung von Frequenz und Phase eines Ausgangstaktsignals (es) in Abhängigkeit von einem Referenzsignal (rs) wird ein digitaler Phasenregelkreis (DPLL) angegeben, der einen aus einer Umschalteinheit (MUX) und mehreren seriell angeordneten Laufzeitgliedern (L) gebildeten Ringoszillator (ROS) zur Erzeugung des Ausgangstaktsignals (es) und einen Phasenvergleicher (PV) zum Vergleichen der Phase des Referenzsignals (rs) und des Ausgangstaktsignals (es) sowie zumindest eine umschaltbare Frequenzteilereinheit (T2) und eine Steuereinheit (CU) zur Regelung der Ringoszillatorfrequenz durch Zu- oder Abschalten von Laufzeitgliedern (L) mit Hilfe der Umschalteinheit (MUX) umfaßt.

## Beschreibung

Die Erfindung betrifft einen digitalen Phasenregelkreis zur Regelung von Frequenz und Phase eines Ausgangstaktsignals in Abhängigkeit von einem Referenzsignal.

Derzeitige und zukünftige digitale Kommunikationsnetze sind weitgehend transparent hinsichtlich der eingesetzten Datenübertragungsraten sowie ermöglichen den Einsatz von unterschiedlichen Übertragungsverfahren bzw. Übertragungsprotokollen - beispielsweise Synchrone Digital Hierachie (SDH), Plesynchrone Digital Hierachie (PDH) und Gigabit-Ethernet - zur Übermittlung von digitalen Informationen. In derartigen digitalen Kommunikationsnetzen ist es erforderlich Einrichtungen zur Datenregeneration bzw. zur Wiederherstellung der Amplitude, Flanke und des Taktes des übermittelten, digitalen Datenstromes vorzusehen.

Hierzu sind digitale Phasenregelkreise (Digital Phase Locked Loop, DPLL) bekannt, die zur Taktrückgewinnung bzw. zur Erzeugung eines Taktsignals aus dem übermittelten, digitalen Datenstrom eingesetzt werden. Derartige digitale Phasenregelkreise umfassen üblicherweise analoge oder digitale, spannungsgesteuerte Oszillatoren zur Erzeugung eines Ausgangstaktsignals, digitale Frequenzteiler und Phasen- bzw. Frequenzdiskriminatoren zum Vergleichen des Ausgangstaktsignals mit einem externen Referenzsignal. Die Funktion derartiger digitaler Phasenregelkreise zur Rückgewinnung des Taktes aus einem digitalen Datenstrom ist dem Fachmann hinreichend bekannt, so daß auf deren Funktionsweise nicht näher eingegangen wird.

Des weiteren ist es insbesondere für Digitalsignal-Multiplexgeräte innerhalb eines digitalen Kommunikationsnetzes erforderlich, mehrere unterschiedliche Übertragungsverfahren bzw. unterschiedliche Übertragungsprotokolle - beispielsweise Synchrone Digitale Hierachie (SDH) und Plesynchrone Digital Hierachie (PDH) - zu unterstützen, d.h. die Daten aus dem übertragenen, digitalen Datenstrom rückgewinnen zu können gleich nach welchem Übertragungsprotokoll bzw. mit welcher Übertragungsrate die Daten übertragen wurden. Deshalb sind auf derartigen Digitalsignal-Multiplexgeräten Schnittstellenbaugruppen vorzusehen, die sowohl das SDH-Protokoll mit einer Übertragungsrate von 155.52 MHz als auch das PDH-Protokoll mit einer geringeren Übertragungsrate von 139.149 MHz unterstützen bzw. im SDH- bzw. PDH-Modus betrieben werden können. Hierzu umfassen üblicherweise derartige umschaltbare Schnittstellenbaugruppen zumindest zwei analoge bzw. digitale PLL's, wobei die eine PLL im SDH-Modus und die andere PLL im PDH-Modus betrieben wird und abhängig von den ankommenden digitalen Daten bzw. dem Datenstrom zwischen den beiden PLL's umgeschaltet wird.

Zusätzlich ist zur Taktrückgewinnung von unterschiedlichen gedemultiplexten Kanälen des digitalen Datenstromes ein zu den Daten des jeweiligen gedemultiplexten Kanals passendes Taktsignal rückzugewinnen, wobei die Übertragungsrate bzw. der Lückentakt der unterschiedlichen durch Demultiplexen des ankommenden, digitalen Datenstromes rückgewonnenen Kanäle von der Übertragungsrate bzw. von dem Übertragungstakt des Kommunikationssystems geringfügig abweichen kann bzw. das rückgewonnene Taktsignal Phasenschwankungen ("Jitter") aufweisen kann. Die nach Kanälen getrennten Daten werden mit ihrem Lückentakt vor der weiteren Übertragung an das Kommunikationssystem in einem Pufferspeicher eingelesen und zwischengespeichert. Zum Auslesen der nach Kanälen getrennten Daten wird zur Erzeugung eines stabilen und jitterarmen Taktsignals jeweils pro Kanal ein digitaler Phasenregelkreis PLL eingesetzt. Hierzu sind zusätzliche Phasenregelkreise hoher Güte aufgrund der Anforderung an die Jitterdämpfung notwendig.

Der vorliegenden Erfindung liegt daher die Aufgabe zugrunde, einen digitalen Phasenregelkreis für unterschiedliche Frequenzbänder mit jeweils mehreren wählbaren Phasen anzugeben. Die Aufgabe wird ausgehend von einem digitalen Phasenregelkreis gemäß den Merkmalen des Patentanspruches 1 gelöst.

Gelöst wird die Aufgabe erfindungsgemäß durch einen digitalen Phasenregelkreis zur Regelung von Frequenz und Phase eines Ausgangstaktsignals in Abhängigkeit von einem Referenzsignal, der einen aus einer Umschalteinheit und mehreren seriell angeordneten Laufzeitgliedern gebildeten Ringoszillator zur Erzeugung des Ausgangstaktsignals und einen Phasenvergleicher zum Vergleichen der Phase des Referenzsignals und des Ausgangstaktsignals aufweist. Des weiteren umfaßt der digitale Phasenregelkreis zumindest eine umschaltbare Frequenzteilereinheit und eine Steuereinheit zur Regelung der Ringoszillatorfrequenz durch das Zu- oder Abschalten von Laufzeitgliedern mit Hilfe der Umschalteinheit. Hierdurch wird besonders vorteilhaft mit Hilfe mehrerer Laufzeitglieder ein Ringoszillator digital realisiert, wobei die Ausgänge der Laufzeitglieder an die Eingänge der Umschalteinheit angeschlossen sind, d.h. die Rückführung des Ringoszillators ist umschaltbar. Durch das erfindungsgemäße Zu- oder Abschalten eines oder mehrerer Laufzeitglieder kann mit Hilfe der Umschalteinheit und der Steuereinheit die Ringoszillatorfrequenz individuell geregelt werden. Des weiteren liegen vorteilhaft bei einer festgelegten Anzahl seriell geschalteter Laufzeitglieder des Ringoszillators an den Ausgängen der Laufzeitglieder jeweils dieselbe Frequenz aufweisende Ausgangstaktsignale an, wobei diese Ausgangstaktsignale unterschiedliche Phasenlagen aufweisen. Somit können sämtliche Phasenlagen des Ausgangstaktsignals an den jeweiligen Ausgängen der Laufzeitglieder mit Hilfe der Umschalteinheit abgegriffen werden. Der erfindungsgemäße digitale Phasenregelkreis kann kostengünstig und resourcenschonend rein digital beispielsweise in einem ASIC (Application-Specific-Integrated-Circuit) realisiert werden, wodurch das Vorsehen eines externen Oszillators entfällt. Somit wird besonders vorteilhaft aufgrund der geringen Anzahl elektronischer Bauteile das "Layouten" der elektronischen Schaltung vereinfacht, die Störstrahlung reduziert und eine größere Packungsdichte der einzelnen Schnittstellen pro Baugruppe ermöglicht.

Ein weiterer wesentlicher Vorteil der Erfindung ist darin zu sehen, daß eine weitere Umschalteinheit zur Erzeugung eines rückgewonnenen Ausgangstaktsignals mit gegenüber dem Ausgangstaktsignal geringfügig unterschiedlicher Phasenlage und Frequenz durch fortlaufendes, zyklisches Abgreifen der an den Ausgängen der Laufzeitglieder des Ringoszillators anliegenden, jeweils eine unterschiedliche Phase aufweisenden Signale vorgesehen ist - Anspruch 2. Vorteilhaft wird erfindungsgemäß durch eine weitere Umschalteinheit ein rückgewonnenes Ausgangstaktsignal mit geringfügig unterschiedlicher Phase und Frequenz im Vergleich zum Ausgangstaktsignal abgegriffen und mit Hilfe dieses rückgewonnenen, stabilen und jitterarmen Ausgangstaktsignals wird beispielsweise der Pufferspeicher einer Eingangsschnittstellenbaugruppe eines Digital-Multiplexers ein- bzw. ausgelesen. Des weiteren können durch das erfindungsgemäße Vorsehen einer weiteren Umschalteinheit, beispielsweise eines digital realisierten Multiplexers, die einen unterschiedlichen Frequenzoffset bzgl. des Referenzsignals aufweisenden Ausgangstaktsignale einer Vielzahl von Kanälen rückgewonnen werden und zum Auslesen des jeweiligen Pufferspeichers eingesetzt werden. Durch die erfindungsgemäße Kombination eines Multiplexers und eines digitalen Ringoszillators wird die Anzahl der zur Taktrückgewinnung der einzelnen Übertragungskanäle benötigen Phasenregelkreise auf nahezu einen einzigen digitalen Phasenregelkreis reduziert, der mehrere erfindungsgemäße "Auskopplungseinheiten" bzw. Umschalteinheiten aufweist. Zusätzlich ist die Erzeugung des Ausgangstaktsignals und die Taktrückgewinnung eines bzgl. des Ausgangstaktsignals eine geringe Frequenzdifferenz aufweisenden, rückgewonnenen Ausgangstaktsignals nahezu vollständig entkoppelt.

Gemäß einer weiteren Ausgestaltung der Erfindung sind mindestens ein Phasenvergleicher und mindestens eine umschaltbare, zwischen Ringoszillator und Phasenvergleicher eingeschaltete Frequenzteilereinheit vorgesehen, so daß Ausgangstaktsignale mit unterschiedlichen Frequenzen erzeugbar sind - Anspruch 3. Mit Hilfe des erfindungsgemäßen umschaltbaren Frequenzteilereinheit ist es auf vorteilhafte Weise möglich Frequenzen innerhalb des durch zwei benachbarte Laufzeitglieder festgelegten Frequenzintervalls zu erzeugen, indem in einem bestimmten Verhältnis zwischen dem Signal am Ausgang des einen Laufzeitgliedes und dem Signal am Ausgang des benachbarten Laufzeitgliedes zyklisch umgeschaltet wird. Somit können durch regelmäßiges Abgreifen der an den Ausgängen benachbarter Laufzeitglieder anliegenden, jeweils eine unterschiedliche Phase aufweisenden Signale Ausgangstaktsignale mit Zwischenfrequenzen zwischen den Eigenfrequenzen des Ringoszillators erzeugt werden, wobei die Auswahl des abzugreifenden Signals nach Maßgabe des aus der Computergraphik bekannten "Bresenham-Algorithmus" durchgeführt wird.

Ein weiterer wesentlicher Vorteil des erfindungsgemäßen Phasenregelkreises ist darin zu sehen, daß die Frequenzteilereinheit einen ersten und zweiten Teilerzähler aufweist, wobei der Zählerstand des ersten Teilerzählers die Anzahl der Taktperioden, in denen ein eine erste Frequenz aufweisendes Ausgangstaktsignal anliegt, bestimmt und der Zählerstand des zweiten Teilerzählers die Anzahl der zugehörigen Taktperioden, in denen ein eine zweite, benachbarte Frequenz aufweisendes Ausgangstaktsignal anliegt, bestimmt und daß anhand der Zählerstände des ersten und zweiten Teilerzählers ein Ausgangstaktsignal mit einer zwischen einer ersten und einer zweiten, benachbarten Frequenz liegenden Frequenz erzeugt werden kann - Anspruch 6. Vorteilhaft können mit Hilfe des in der Frequenzteilereinheit vorgesehen ersten und zweiten Teilerzählers auch Ausgangstaktsignale mit einer Frequenz erzeugt werden, die zwischen den Frequenzen der vom Ringoszillator abgreifbaren Ausgangstaktsignalen liegen.

Nach einer weiteren Ausgestaltung der Erfindung sind ein erster und zweiter Zähler vorgesehen, wobei der erste Zähler mit einem ersten ganzzahligen Startwert N1 und der zweite Zähler mit einen zweiten ganzzahligen Startwert N2 durch eine Flanke des Referenzsignals gestartet wird und das Verhältnis des ersten zum zweiten Startwert N1/N2 durch das geforderte Verhältnis des Ausgangstaktsignals zum Referenzsignal festgelegt ist. Des weiteren wird anhand der Reihenfolge des Ablaufens des ersten und zweiten Zählers ein erstes Steuersignal zum Zu- oder Abschalten von Laufzeitgliedern innerhalb des Ringoszillators durch die Umschalteinheit erzeugt - Anspruch 7. Durch die Verwendung eines ersten und zweiten Zählers, die mit beispielsweise der aufsteigenden Flanke des Referenzsignals gestartet werden, wird auf vorteilhafte Weise die Frequenz des Ausgangstaktsignals an die Frequenz des Referenzsignals angenähert, d.h. abhängig davon welcher Zähler zuerst abgelaufen ist wird mit Hilfe des durch die Steuereinheit erzeugten ersten Steuersignals durch die Umschalteinheit ein weiteres Laufzeitglied zu- oder abgeschaltet. Diese Annäherung wird solange durchgeführt bis die geteilte Ringoszillatorfrequenz bis auf eine geringe Frequenzdifferenz mit der geteilten Frequenz des Referenzsignals übereinstimmt.

Gemäß einer weiteren Ausgestaltung der Erfindung sind ein dritter und vierter zirkularer Zähler vorgesehen, wobei der dritte zirkulare Zähler mit einem dritten ganzzahligen Startwert N3 und der vierte zirkulare Zähler mit einem vierten ganzzahligen Startwert N4 durch eine Flanke des Referenzsignals gestartet werden und der Zählerstand des dritten Zählers jeweils mit einer Taktflanke des geteilten Referenzsignals und der Zählerstand des vierten Zählers jeweils mit einer Taktflanke des geteilten Ausgangstaktsignals um eine Zähleinheit verringert werden. Des weiteren ist das Verhältnis des dritten und vierten Startwertes N3/N4 durch das geforderte Verhältnis des Referenzsignals zum Ausgangstaktsignal festgelegt und der Zählerstand des dritten und vierten zirkularen Zählers werden beim Nulldurchgang des dritten oder vierten Zählers verglichen sowie anhand des Vergleichsergebnisses der Zählerstand des ersten und/oder zweiten Teilerzählers erhöht oder erniedrigt - Anspruch 8. Hierdurch kann auf besonders vorteilhafte Weise eine "Feinregelung" des Ausgangssignals hinsichtlich des Referenzsignals realisiert werden, wobei die "Feinregelung" des digitalen Phasenregelkreises im eingeschwungenen Zustand nahezu ununterbrochen durchgeführt wird.

Ein weiterer wesentlicher Aspekt der Erfindung ist darin zu sehen, daß mit Hilfe eines durch die Steuereinheit erzeugten zweiten Steuersignals jeweils durch die weitere Umschalteinheit ein rückgewonnenes Ausgangstaktsignal mit einer festgelegten Taktphase und Frequenz durchgeschaltet wird und das zweite Steuersignal durch einen Registerwert repräsentiert wird. Desweiteren wird der Registerwert durch einen durch das Referenzsignal getakteten, synchronen Zähler gebildet und zur Erhöhung bzw. Verringerung der Taktphase und Frequenz des rückgewonnenen Ausgangstaktsignals der synchrone Zähler um jeweils einen vorgegebenen ganzzahligen Krement-Wert in- bzw. dekrementiert - Anspruch 10. Somit ist der vorgegebene ganzzahlige Krement-Wert zur Offsetbildung zwischen Referenzsignal und rückgewonnenen Ausgangstaktsignal vorgesehen - Anspruch 11. Dadurch können auf besonders einfache Weise Ausgangstaktsignale erzeugt werden, die einen festgelegten bzw. einstellbaren Offset hinsichtlich des Referenzsignals aufweisen. Beispielsweise müssen die Daten beim Auslesen eines Pufferspeichers einer Eingangseinheit eines Übertragungssystems nahezu mit demselben Takt ausgelesen werden mit dem sie in den Pufferspeicher eingelesen wurden. Die Regeneration eines derartigen Takts aus dem ankommenden Datenstrom bzw. Datensignalen wird durch die Anwendung der Erfindung aufgrund der bereits im Ringoszillator vorliegenden unterschiedlichen Phasenlagen des Ausgangstaktsignals erheblich vereinfacht, d.h. die erfindungsgemäße Regeneration ist ohne erheblichen schaltungstechnischen Aufwand, insbesondere ohne das Vorsehen eines zusätzlichen analogen Oszillators, realisierbar.

Vorteilhafte Weiterbildungen und Ausbildungen des erfindungsgemäßen digitalen Phasenregelkreises sind in den weiteren Patentansprüchen beschrieben.

Die Erfindung wird im folgenden anhand von bevorzugten Ausführungsbeispielen unter Bezugnahme auf die Figuren im Detail erläutert, in denen
- Figur 1: ein Blockschaltbild eines ersten Ausführungsbeispiels des erfindungsgemäßen digitalen Phasenregelkreises zeigt,
- Figur 2: ein Blockschaltbild eines zur Realisierung des erfindungsgemäßen digitalen Phasenregelkreises vorgesehenen Ringoszillators zeigt und
- Figur 3: in einem Blockschaltbild die Verwendung des erfindungsgemäßen digitalen Phasenregelkreises zur Taktrückgewinnung für eine Eingangs- und Ausgangseinheit zeigt.

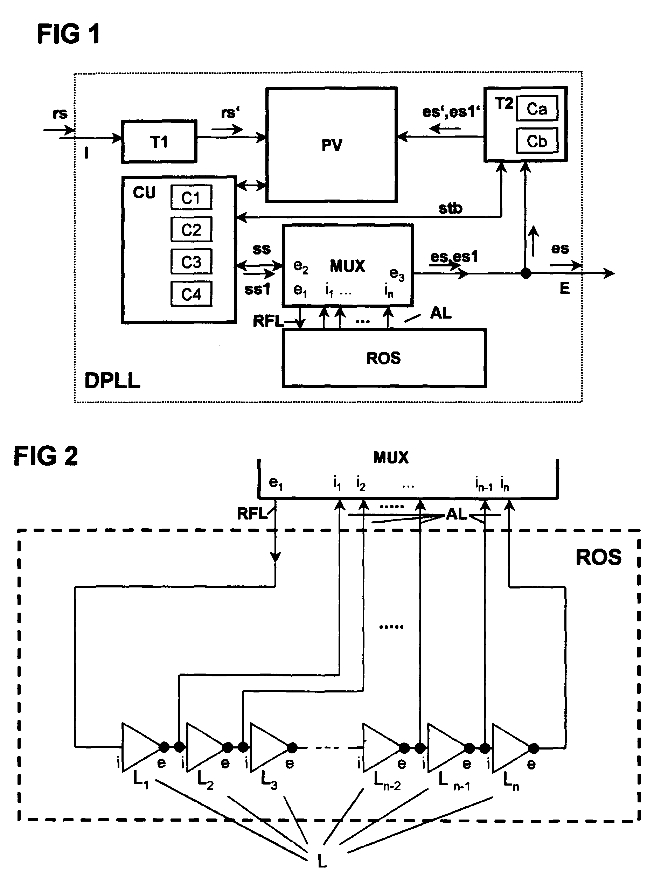

**Figur 1** zeigt ein Blockschaltbild eines erfindungsgemäßen digitalen Phasenregelkreises DPLL, der eine erste und eine zweite umschaltbare Frequenzteilereinheit T1,T2, einen Phasenvergleicher PV, eine Steuereinheit CU, eine Umschalteinheit MUX und einen Ringoszillator ROS aufweist, wobei die Umschalteinheit MUX beispielsweise eine Vielzahl von Eingängen i₁ bis iₙ und einen ersten, zweiten und dritten Ausgang e₁ bis e₃ aufweist. Die erste und zweite umschaltbare Frequenzteilereinheit T1,T2 ist jeweils mit dem Phasenvergleicher PV verbunden. Desweiteren weist die zweite umschaltbare Frequenzteilereinheit T2 einen ersten und zweiten Teilerzähler Ca,Cb auf und ist mit der Steuereinheit CU und mit der Umschalteinheit MUX verbunden, an die der Ringoszillator ROS über eine Vielzahl von Anschlußleitungen AL und einer Rückführungsleitung RFL angeschlossen ist. Die Umschalteinheit MUX ist an die Steuereinheit CU angeschlossen, wobei die Steuereinheit CU zusätzlich mit dem Phasenvergleicher PV verbunden ist. Desweiteren weist die Steuereinheit CU einen ersten und zweiten Zähler C1,C2 sowie einen dritten und vierten, zirkularen Zähler C3,C4 auf.

Am Eingang I des digitalen Phasenregelkreises DPLL liegt ein Referenzsignal rs an, daß an die erste Frequenzteilereinheit T1 übertragen wird. Mit Hilfe der ersten Frequenzteilereinheit T1 wird die Frequenz des Referenzsignals rs verringert und somit das Referenzsignal rs an den Arbeitsfrequenzbereich des Phasenvergleichers PV angepaßt. Anschließend wird das geteilte Referenzsignal rs' an den Phasenvergleicher PV übermittelt.

Des weiteren wird über die Umschalteinheit MUX, die beispielsweise als Multiplexer realisiert ist, ein vom Ringoszillator ROS erzeugtes Ausgangstaktsignal es an den Ausgang E des digitalen Phasenregelkreises DPLL und an die zweite umschaltbare Frequenzteilereinheit T2 übertragen. Durch die zweite umschaltbare Frequenzteilereinheit T2 wird die Frequenz des Ausgangstaktsignal es zur Anpassung an den Arbeitsfrequenzbereich des Phasenvergleichers PV geteilt und das geteilte Ausgangstaktsignal es' an den Phasenvergleicher PV weitergeleitet. Das Teilungsverhältnis der zweiten umschaltbaren Frequenzteilereinheit T2 wird durch die Steuereinheit CU mit Hilfe von Teilungssteuerbefehlen stb anhand der Zählerstände des ersten und zweiten Teilerzählers Ca,Cb geregelt.

Im Phasenvergleicher PV werden das geteilte Referenzsignal rs' und das geteilte Ausgangstaktsignal es' hinsichtlich ihrer Frequenz und Phasenlage verglichen, wobei zum Feststellen eines Frequenzunterschiedes in der Steuereinheit CU der erste und zweite Zähler C1,C2 sowie zum Erkennen eines Phasenunterschiedes der dritte und vierte, zirkulare Zähler C3,C4 vorgesehen sind. Ausgehend von den ermittelten Frequenz- und Phasenunterschieden zwischen Referenz- und Ausgangstaktsignal rs,es werden in der Steuereinheit CU Steuersignale ss zur Steuerung der Umschalteinheit MUX sowie Teilungssteuerbefehle stb zur Anpassung des Teilungsverhältnisses der zweiten umschaltenbaren Frequenzteilereinheit T2 gebildet und an die Multiplexereinheit MUX bzw. an die zweite umschaltbare Frequenzteilereinheit T2 weitergeleitet. Mit Hilfe der übermittelten Steuersignale ss wird durch die Umschalteinheit MUX die Ringoszillatorfrequenz geregelt und ein hinsichtlich der Frequenz korrigiertes Ausgangstaktsignal es gewonnen. Das korrigierte Ausgangstaktsignal es wird wiederum an den Ausgang E des digitalen Phasenregelkreises DPLL sowie an die zweite umschaltbare Frequenzteilereinheit T2 weitergeleitet und somit erneut dem Regelkreis zugeführt.

Desweiteren ist zur Erläuterung der Erfindung in **Figur 2** der Aufbau des bereits in Figur 1 dargestellten Ringoszillators ROS schematisch dargestellt. Der Ringoszillator ROS besteht aus mehreren, seriell angeordneten Lautzeitgliedern L₁ bis Lₙ, wobei die Laufzeitglieder L₁ bis Lₙ sowohl als Verzögerungsglieder als auch als Inverter realisiert sein können. In dem in Figur 2 dargestellten Ausführungsbeispiel sind ein erster bis n-ter Inverter L₁ bis Lₙ dargestellt, wobei die Inverter L₁ bis Lₙ in Serie geschaltet sind und jeder Inverter L₁ bis Lₙ jeweils einen Eingang i und einen Ausgang e aufweist. Die Rückführung des Ringoszillators ROS erfolgt über die Umschalteinheit MUX des digitalen Phasenregelkreises DPLL. Hierzu ist jeweils der Ausgang e des ersten bis n-ten Inverters L₁ bis Lₙ an einen Eingang i₁ bis iₙ der Umschalteinheit MUX angeschlossen und über die an den ersten Ausgang e1 der Umschalteinheit MUX angeschlossene Rückführungsleitung RFL wird der zur Erzeugung einer Schwingung benötigte rückgekoppelte Schwingkreis geschlossen. Die Rückführung des Ringoszillators ROS ist mit Hilfe der Umschalteinheit MUX umschaltbar ausgestaltet, so daß durch Zu- oder Abschalten beispielsweise von Invertern L₁ bis Lₙ die Ringoszillatorfrequenz verändert werden kann. Desweiteren weist das bei geschlossenen Schwingkreis an den Ausgängen e der jeweiligen Inverter L₁ bis Lₙ anliegende Ausgangstaktsignal es unterschiedliche Phasenlagen aus, die zur Korrektur der Phasendifferenz zwischen Referenzsignal rs und Ausgangstaktsignal es herangezogen werden können.

Die in **Figur 1** dargestellte Steuereinheit CU ist zur Regelung des Phasenregelkreises DPLL vorgesehen, wobei hierbei die Regelung in zwei "Phasen" gegliedert werden kann - die "Grob"- und die "Fein"-Regelung des Phasenregelkreises DPLL. Zunächst wird bei Inbetriebnahme des Phasenregelkreises DPLL das Anschwingen des digitalen Phasenregelkreises bzw. des Ringoszillators durch die Steuereinheit CU mit Hilfe eines an die Umschalteinheit MUX übermittelten Steuersignals ss durchgeführt, wobei durch das Steuersignals ss eine beliebig festgelegte Anzahl von Invertern L₁ bis Lₙ mit Hilfe der Umschalteinheit MUX durchgeschaltet wird und somit ein erstes Ausgangssignal es1 mit einer stabilen Frequenz erzeugt wird. Nach Vorliegen dieses ersten Ausgangssignals es1 am dritten Ausgang e₃ der Umschalteinheit MUX wird die Frequenz des ersten Ausgangssignal es1 durch die zweite Frequenzteilereinheit T2 an den Arbeitsfrequenzbereich des Phasenvergleichers PV angepaßt. Anschließend werden das geteilte erste Ausgangssignal es1' und das geteilte Referenzsignal rs' im Phasewnvergleicher PV verglichen. Hierbei werden der in der Steuereinheit CU vorgesehene erste und zweite Zähler C1,C2, beispielsweise digitale Rückwärtszähler, durch eine Flanke des Referenzsignals gestartet, wobei der erste Zähler C1 einen ersten ganzzahligen Startwert N1 und der zweite Zähler C2 einen zweiten ganzzahligen Startwert N2 aufweisen, deren Verhältnis zueinander durch das zu regelnde bzw. geforderte Verhältnis des Referenzsignals zum Ausgangstaktsignal festgelegt ist. Anhand der Reihenfolge des Ablaufens des ersten und zweiten Zählers C1,C2 wird von der Steuereinheit CU ein erstes Steuersignal ss1 gebildet, daß zur Umschalteinheit MUX übertragen ein Zu- oder Abschalten eines oder mehrerer Laufzeitgliedes(er) bzw. Inverters(er) Lₙ innerhalb des Ringoszillators ROS bewirkt. Hierdurch wird die Frequenz des Ausgangstaktsignals es "grob" geregelt, d.h. es kann nach mehrfachen Regeldurchläufen die Frequenz des Ausgangstaktsignals es soweit an die Frequenz des Referenzsignal rs angenähert werden bis die Anzahl der Laufzeitglieder bzw. Inverter L des Ringoszillators ROS zur Erzeugung der Referenzfrequenz auf einen oder zwei benachbarte Werte genau festgelegt ist.

Im Anschluß an die "Grob"-Regelung der Frequenz des Ausgangstaktsignals es wird die "Fein"-Regelung mit Hilfe der zweiten umschaltbaren Frequenzteilereinheit T2 und der in der Steuereinheit CU vorgesehenen dritten und vierten zirkularen Zähler C3,C4 durchgeführt. Hierzu sind die in der zweiten umschaltbaren Frequenzteilereinheit T2 vorgesehen ersten und zweiten Teilerzähler Ca,Cb jeweils mit einem Anfangswert initialisiert, wobei durch den Zählerstand des ersten Teilerzählers Ca die Anzahl der Taktperioden, in denen ein eine erste Frequenz aufweisendes Ausgangstaktsignal es anliegt, und durch den Zählerstand des zweiten Teilerzählers Cb die Anzahl der nachfolgenden Taktperioden, in denen ein eine zweite, benachbarte Frequenz aufweisendes Ausgangstaktsignal es anliegt, bestimmt wird. Somit wird mit Hilfe der Zählerstände des ersten und zweiten Teilerzählers Ca,Cb durch die Steuereinheit CU ein Verhältnis bzw. ein Schaltverhältnis für das Umschalten zwischen zwei Eingängen i₁ bis iₙ der Umschalteinheit MUX zur Erzeugung eines eine Zwischenfrequenz aufweisenden Ausgangstaktsignals es bestimmt, welches mit Hilfe von ersten Steuersignalen ss1 an die Umschalteinheit übermittelt wird. Zur Übermittlung der unterschiedlichen Steuersignale ss,ss1 kann von der Steuereinheit CU zur Umschalteinheit MUX beispielsweise ein Steuerbus vorgesehen sein - in Figur 1 nicht dargestellt.

Desweiteren werden zur "Fein"-Regelung die in der Steuereinheit vorgesehenen, dritten und vierten zirkularen Zähler C3,C4 eingesetzt, wobei der dritte Zähler C3 mit einem dritten ganzzahligen Startwert N3 und der vierte Zähler C4 mit einem vierten ganzzahligen Startwert N4 jeweils durch eine Flanke des Referenzsignals rs einmalig gestartet werden und nach einem vollständigen Durchlauf wiederum selbständig den ursprünglichen dritten bzw. vierten Startwert N3,N4 neu laden. Desweiteren ist das Verhältnis des dritten zum vierten Startwert N3/N4 durch das geforderte Verhältnis des Referenzsignals rs zum Ausgangstaktsignal es vorgegeben. Zur "Fein"-Regelung wird der Zählerstand des dritten Zählers C3 jeweils durch eine Flanke des am Phasenvergleicher PV anliegenden geteilten Referenzsignals rs' und der Zählerstand des vierten Zählers C4 jeweils durch eine Flanke des am Phasenvergleicher PV anliegenden geteilten Ausgangstaktsignals es' um eine Zähleinheit verringert bzw. "runtergezählt" werden und der Zählerstand des dritten Zählers C3 mit dem des vierten Zählers C4 beim Nulldurchgang des vierten Zählers C4 verglichen, d.h. die "Wanderrichtung" des Nulldurchgangs beispielsweise des vierten Zählers C4 hinsichtlich des Zählerstands des dritten Zählers C3 gibt Aufschluß darüber, ob die Frequenz des Ausgangstaktsignals es verringert oder erhöht werden muß, um die Frequenz des Ausgangstaktsignals es an die Frequenz des Referenzsignals rs anzunähern. Somit wird anhand des Vergleichsergebnisses der Zählerstand des ersten und/oder zweiten Teilerzählers Ca,Cb erhöht oder erniedrigt. Dadurch kann die Frequenz des Ringoszillators ROS bzw. des Ausgangstaktsignals es erhöht werden, indem der Zählerstand des ersten Teilerzählers Ca verringert oder der Zählerstand des zweiten Teilerzählers Cb erhöht wird, vorausgesetzt daß der erste Teilerzähler Ca Taktperioden, in denen ein eine erste Frequenz aufweisendes Ausgangstaktsignal es anliegt, repräsentiert und der zweite Teilerzähler Cb Taktperioden, in denen ein eine zweite, im Vergleich zur ersten höheren Frequenz aufweisendes Ausgangstaktsignal es anliegt, repräsentiert. Analog dazu kann die Frequenz des Ringoszillators ROS bzw. des Ausgangstaktsignals es verringert werden, indem der Zählerstand des ersten Teilerzählers Ca erhöht oder der Zählerstand des zweiten Teilerzählers Cb verringert wird. Dieses "Durchstimmen" des ersten und zweiten Teilerzählers Ca,Cb erfolgt in Anlehnung an den aus der Computergraphik bekannten "Bresenham-Algorithmus".

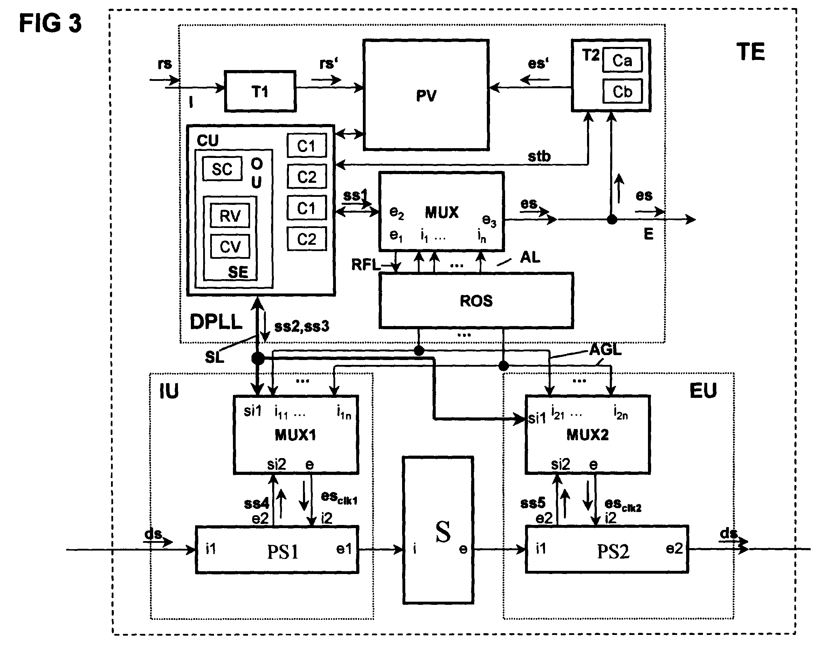

In **Figur 3** ist in einem Blockschaltbild die Verwendung des erfindungsgemäßen digitalen Phasenregelkreises DPLL zur Taktrückgewinnung in einer Eingangseinheit IU und einer Ausgangseinheit EU einer Übertragungseinrichtung TE schematisch dargestellt. Hierzu ist der in der Übertragungseinrichtung TE vorgesehene digitale Phasenregelkreiss DPLL über Steuerleitungen SL an eine Eingangseinheit IU und an eine Ausgangseinheit EU angeschlossen, wobei die an die Übertragungseinrichtung TE übertragenen Daten bzw. der Datenstrom ds zunächst in der Eingangseinheit IU verarbeitet werden und anschließend über das den Kern der Übertragungseinrichtung TE repräsentierende, einen Eingang i und einen Ausgang e aufweisende System S an die Ausgangseinheit EU weitergeleitet werden. In der Ausgangseinheit EU werden die vom System S ankommenden Daten bzw. der Datenstrom ds weiterverarbeitet und an weitere Übertragungseinrichtungen TE übermittelt.

Hierzu weisen die Eingangseinheit IU eine erste weitere Umschalteinheit MUX1 und die Ausgangseinheit EU eine zweite weitere Umschalteinheit MUX2 auf, die jeweils über Phasenanschlußleitungen AGL an den Ringoszillator ROS des digitalen Phasenregelkreises DPLL angeschlossen sind. Desweiteren ist die erste weitere Umschalteinheit MUX1 an den in der Eingangseinheit IU angeordneten ersten Pufferspeicher PS1 und die zweite, weitere Umschalteinheit MUX2 an den in der Ausgangseinheit EU angeordneten zweiten Pufferspeicher PS2 angeschlossen. Der erste und zweite Pufferspeicher PS1,PS2 weisen jeweils einen ersten und zweiten Eingang i1,i2 und einen ersten und zweiten Ausgang e1,e2 auf. Die erste und zweite Umschalteinheit MUX1,MUX2 weisen jeweils erste bis n-te Eingänge i₁₁ bis i₁ₙ, i₂₁ bis i₂ₙ, einen ersten und zweiten Steuereingang si1,si2 und einen Ausgang e auf. Insbesondere sind die ersten bis n-ten Eingänge i₁₁ bis i₁ₙ, i₂₁ bis i₂ₙ der ersten und zweiten Umschalteinheit MUX1,MUX2 über die Phasenanschlußleitungen AGL an den Ringoszillator ROS angeschlossen, über die Ausgangstaktsignale es mit im Vergleich zum Referenzsignal rs unterschiedlicher Phasenlage und Frequenz vom Ringoszillator ROS abgegriffen werden können.

An den ersten Eingang i1 des ersten Pufferspeichers PS1 wird der Datenstrom ds und an den zweiten Eingang i2 das von der ersten weiteren Umschalteinheit MUX1 erzeugte erste rückgewonnene Ausgangstaktsignal es_{CLK1} geführt. Desweiteren ist der erste Ausgang e1 des ersten Pufferspeichers PS1 mit dem Eingang i des Systems S verbunden, wobei der zweite Ausgang e2 des ersten Pufferspeichers PS1 mit dem zweiten Steuereingang si2 der ersten weiteren Umschalteinheit MUX1 verbunden ist.

Analog dazu ist der erste bzw. zweite Eingang i1,i2 des zweiten Pufferspeichers PS2 mit dem Ausgang e des Systems S bzw. mit dem Ausgang e der zweiten weiteren Umschalteinheit MUX2 verbunden. Desweiteren liegt am ersten Ausgang e1 des zweiten Pufferspeichers PS2 der weiter zu vermittelnde Datenstrom bzw. die Daten ds an. Der zweite Ausgang e2 des zweiten Pufferspeichers PS2 ist mit dem zweiten Steuereingang si2 der zweiten weiteren Umschalteinheit MUX2 verbunden.

Zur Steuerung der ersten und zweiten weiteren Umschalteinheit MUX1, MUX2 ist jeweils der erste Steuereingang si1 der ersten und zweiten weiteren Umschalteinheit MUX1, MUX2 über Steuerleitungen an die Steuereinheit CU des digitalen Phasenregelkreises DPLL angeschlossen.

Die am ersten Eingang i1 des ersten Pufferspeichers PS1 ankommenden Daten ds werden im ersten Pufferspeicher PS1 eingelesen und der Füllstand des ersten Pufferspeichers PS1 mit Hilfe eines vierten Steuersignals ss4 an die erste weitere Umschalteinheit MUX1 übertragen. Der zum Einlesen des ersten Pufferspeichers PS1 benötige Takt bzw. das erste rückgewonnene Ausgangstaktsignal es_{CLK1} wird durch die erste weitere Umschalteinheit MUX1 erzeugt und an den zweiten Eingang i2 des ersten Pufferspeicher PS1 übertragen. Hierzu wird ein zweites Steuersignal ss2 mit Hilfe einer in der Steuereinheit CU angeordneten Offseteinheit OU erzeugt.

Die Offseteinheit OU weist eine Speichereinheit SE und einen synchronen Zähler SC auf, wobei in der Speichereinheit SE ein Registerwert RV und ein Krement-Wert CV gespeichert sind. Der synchrone Zähler SC wird durch das Referenzsignal rs getaktet bzw. mit jeder Flanke des Referenzsignals um einen Zählschritt "hochgezählt" und wird nach Erreichen des maximalen Zählerstandes zurückgesetzt. Das zweite Steuersignal ss2 wird in der Speichereinheit SE in der Form des Registerwerts RV, der sich aus einem mehrbitigen Wert zusammensetzt, gespeichert. Mit Hilfe des Registerwerts RV, der über die Steuerleitungen SL zur ersten weiteren Umschalteinheit MUX1 übertragen wird, wird durch die erste weitere Umschalteinheit MUX1 die Phasenlage bzw. Frequenz des zum ersten Pufferspeicher PS1 übertragenen ersten rückgewonnenen Ausgangstaktsignals es_{CLK1} festgelegt. Bleibt der Registerwert RV unverändert, so wird das am Ausgang e der ersten weiteren Umschalteinheit MUX1 anliegende erste rückgewonnene Ausgangstaktsignal es_{CLK1} seine Frequenz beibehalten, d.h. die ankommenden Daten ds werden in den ersten Pufferspeicher PS1 mit einem nahezu der Frequenz des Referenzsignals entsprechenden Takt eingelesen.

Zur Erzeugung eines ersten rückgewonnenen, einen Offset hinsichtlich des Referenzsignals rs aufweisenden Ausgangstaktsignals es_{CLK1} ist der in der Speichereinheit SE gespeicherte Krement-Wert CV vorgesehen, mit dessen Hilfe der synchrone Zähler SC zyklisch jeweils um den Betrag des Krement-Wertes CV de- oder inkrementiert wird. Der dadurch zyklisch erhaltene Zählerstand des synchronen Zählers SC wird als aktueller Registerwert RV gespeichert bzw. der alte Registerwert RV wird mit dem Zählerstand des synchronen Zählers SC überschrieben. Der synchrone Zähler SC wird somit periodisch um jeweils den Krement-Wert CV erhöht bzw. erniedrigt, wodurch am Ausgang e der ersten weiteren Umschalteinheit MUX1 ein erstes rückgewonnenes Ausgangstaktsignal es_{CLK1} mit einer im Vergleich zur Ringoszillatorfrequenz geringeren bzw. höheren Frequenz erzeugt wird.

Die Größe des Offsets bzw. des Krement-Werts CV ist unter anderem abhängig davon welchen Füllzustand der erste Pufferspeicher PS1 aufweist. Der Füllzustand des ersten Pufferspeichers PS1 wird über das vierte Steuersignal ss4 der ersten weiteren Umschalteinheit MUX1 und somit der Steuereinheit CU angezeigt und bei der Bildung des Krement-Werts CV in der Steuereinheit CU berücksichtigt.

In Analogie dazu wird beim Ausgeben der Daten ds auf die Übertragungsstrecke, d.h. für das Auslesen der Daten ds aus dem zweiten Pufferspeicher PS2 der Ausgangseinheit EU ebenfalls ein stabiler, einen Offset hinsichtlich der Frequenz des Referenzsignals rs aufweisender Takt bzw. ein zweites rückgewonnenes Ausgangstaktsignal es_{CLK2} benötigt. Dieses zweite rückgewonnene Ausgangstaktsignal es_{CLK2} wird mit Hilfe der zweiten weiteren Umschalteinheit MUX2 erzeugt. Hierbei wird der Füllstand des zweiten Pufferspeichers PS2 durch ein fünftes Steuersignal ss5 an die zweite weitere Umschalteinheit PS2 übertragen, der bei der Bildung des Krement-Wertes CV in der Steuereinheit CU mitberücksichtig wird. Die vom System S am ersten Eingang i1 des zweiten Pufferspeichers PS2 ankommenden Daten ds werden in den zweiten Pufferspeicher PS2 eingelesen. Des weiteren wird mit Hilfe der Offseteinheit OU analog zur Steuerung der Taktrückgewinnung in der Eingangseinheit IU die zweite weitere Umschalteinheit MUX2 mit Hilfe eines dritten Steuersignals ss3 gesteuert. Anhand des sich am Ausgang e der zweiten weiteren Umschalteinheit MUX2 ergebenden, "offsetierten" zweiten rückgewonnenen Ausgangstaktsignals es_{CLK2} werden die im zweiten Pufferspeicher PS2 gespeicherten Daten ds ausgelesen.

## Patentansprüche

1. Digitaler Phasenregelkreis (DPLL) zur Regelung von Frequenz und Phase eines Ausgangstaktsignals (es) in Abhängigkeit von einem Referenzsignal (rs),
- mit einem aus einer Umschalteinheit (MUX) und mehreren seriell angeordneten Laufzeitgliedern (L) gebildeten Ringoszillator (ROS) zur Erzeugung des Ausgangstaktsignals (es),
- mit einem Phasenvergleicher (PV) zum Vergleichen der Phase des Referenzsignals (rs) und des Ausgangstaktsignals (es),
- mit zumindest einer umschaltbaren Frequenzteilereinheit (T2) und
- mit einer Steuereinheit (CU) zur Regelung der Ringoszillatorfrequenz durch Zu- oder Abschalten von Laufzeitgliedern (L) mit Hilfe der Umschalteinheit (MUX).

2. Digitaler Phasenregelkreis nach Anspruch 1,
**dadurch gekennzeichnet,**
daß eine weitere Umschalteinheit (MUX1,MUX2) zur Erzeugung eines rückgewonnenen Ausgangstaktsignals (es_{CLK1},es_{CLK2}) mit gegenüber dem Ausgangstaktsignal (es) geringfügig unterschiedlichen Phasenlage und Frequenz durch fortlaufendes, zyklisches Abgreifen der an den Ausgängen (e) der Laufzeitglieder (L) des Ringoszillators (ROS) anliegenden, jeweils eine unterschiedliche Phase aufweisenden Signalen vorgesehen ist.

3. Digitaler Phasenregelkreis nach Anspruch 1 oder 2,
**dadurch gekennzeichnet,**
daß mindestens ein Phasenvergleicher (PV) und mindestens eine umschaltbare, zwischen Ringsoszillator (ROS) und Phasenvergleicher (PV) eingeschaltete Frequenzteilereinheit (T2) vorgesehen sind, so daß bei unverändertem Referenzsignal (rs) Ausgangstaktsignale (es) mit unterschiedlichen Frequenzen erzeugbar sind.

4. Digitaler Phasenregelkreis nach einem der Ansprüche 1 bis 3,
**dadurch gekennzeichnet,**
daß die Umschalteinheit (MUX,MUX1,MUX2) ein Multiplexer ist.

5. Digitaler Phasenregelkreis nach einem der Ansprüche 1 bis 4,
**dadurch gekennzeichnet,**
daß die Laufzeitglieder (L) als Inverter oder als Verzögerungsglieder realisierbar sind.

6. Digitaler Phasenregelkreis nach einem der Ansprüche 1 bis 5,
**dadurch gekennzeichnet,**
daß die Frequenzteilereinheit (T2) einen ersten und zweiten Teilerzähler (Ca,Cb) aufweist, wobei der Zählerstand des ersten Teilerzählers (Ca) die Anzahl der Taktperioden, in denen ein eine erste Frequenz aufweisendes Ausgangstaktsignal (es) anliegt, bestimmt und der Zählerstand des zweiten Teilerzählers (Cb) die Anzahl der zugehörigen Taktperioden, in denen ein eine zweite, benachbarte Frequenz aufweisendes Ausgangstaktsignal (es) anliegt, bestimmt und
daß anhand der Zählerstände des ersten und zweiten Teilerzählers (Ca,Cb) ein Ausgangstaktsignal (es) mit einer zwischen einer ersten und einer zweiten, benachbarten Frequenz liegenden Frequenz erzeugt werden kann.

7. Digitaler Phasenregelkreis nach einem der Ansprüche 1 bis 6,
**dadurch gekennzeichnet,**
daß ein erster und zweiter Zähler (C1,C2) vorgesehen sind, wobei der erste Zähler (C1) mit einem ersten ganzzahligen Startwert N1 und der zweite Zähler (C2) mit einem zweiten ganzzahligen Startwert N2 durch eine Flanke des Referenzsignals (rs) gestartet wird,
daß das Verhältnis des ersten zum zweiten Startwert N1/N2 durch das geforderte Verhältnis des Referenzsignals (rs) zum Ausgangstaktsignal (es) festgelegt ist und
daß anhand der Reihenfolge des Ablaufens des ersten und zweiten Zählers (C1,C2) ein erstes Steuersignal (ss1) zum Zu- oder Abschalten von Laufzeitgliedern (L) innerhalb des Ringoszillators (ROS) durch die Umschalteinheit (MUX) erzeugt wird.

8. Digitaler Phasenregelkreis nach Anspruch 6,
**dadurch gekennzeichnet,**
daß ein dritter und vierter zirkularer Zähler (C3,C4) vorgesehen sind, wobei der dritte zirkulare Zähler (C3) mit einem dritten ganzzahligen Startwert N3 und der vierte zirkulare Zähler (C4) mit einem vierten ganzzahligen Startwert N4 durch eine Flanke des Referenzsignals (rs) gestartet werden und der Zählerstand des dritten Zählers (C3) jeweils mit einer Taktflanke des geteilten Referenzsignals (rs') und der Zählerstand des vierten Zählers (C4) jeweils mit einer Taktflanke des geteilten Ausgangstaktsignals (es') um eine Zähleinheit verringert werden,
daß das Verhältnis des dritten und vierten Startwertes N3/N4 durch das geforderte Verhältnis des Referenzsignals (rs) zum Ausgangstaktsignal (es) festgelegt ist,
daß der Zählerstand des dritten und vierten zirkularen Zählers (C3,C4) beim Nulldurchgang des dritten oder vierten Zählers (C3,C4) verglichen werden und
daß anhand des Vergleichsergebnisses der Zählerstand des ersten und/oder zweiten Teilerzählers (Ca,Cb) erhöht oder erniedrigt wird.

9. Digitaler Phasenregelkreis nach einem der Ansprüche 1 bis 8,
**dadurch gekennzeichnet,**
daß bei Ausfall des Referenzsignals (rs) das zuletzt erzeugte Ausgangstaktsignal (es) weiterhin erzeugt wird.

10. Digitaler Phasenregelkreis nach einem der Ansprüche 1 bis 9,
**dadurch gekennzeichnet,**
daß mit Hilfe eines durch die Steuereinheit erzeugten zweiten Steuersignals (ss2) jeweils durch die weitere Umschalteinheit (MUX1,MUX2) ein rückgewonnenes Ausgangstaktsignal (es_{CLK1},es_{CLK2}) mit einer festgelegten Taktphase und Frequenz durchgeschaltet wird,
daß das zweite Steuersignal (ss2) durch einen Registerwert (RV) repräsentiert wird, der durch einen durch das Referenzsignal (rs) getakteten, synchronen Zähler (SC) gebildet wird und
daß zur Erhöhung bzw. Verringerung der Taktphase und Frequenz des rückgewonnenen Ausgangstaktsignals (es_{CLK1},es_{CLK2}) der synchrone Zähler (SC) um jeweils einen vorgegebenen ganzzahligen Krement-Wert (CV) in- bzw. dekrementiert wird.

11. Digitaler Phasenregelkreis nach Anspruch 10,
**dadurch gekennzeichnet,**
daß der vorgegebene ganzzahlige Krement-Wert (CV) zur Offsetbildung zwischen Referenzsignal (rs) und rückgewonnenen Ausgangstaktsignal (es_{CLK1},es_{CLK2}) vorgesehen ist.

12. Digitaler Phasenregelkreis nach einem der Ansprüche 1 bis 11,
**dadurch gekennzeichnet,**
daß zur Erzeugung mehrerer einen unterschiedlich geringen Frequenzoffset bezüglich des Referenzsignals (rs) aufweisenden, rückgewonnenen Ausgangstaktsignalen (es_{CLK1},es_{CLK2}) mehreren weiteren Umschalteinheiten (MUX2) vorsehbar sind, wobei die weiteren Umschalteinheiten (MUX2) an den Ringoszillator (ROS) angeschlossenen sind.
